# EUROPEAN PATENT APPLICATION

(11) **EP 4 626 152 A1**
(43) Date of publication of application: **01.10.2025**
(21) Application number: 25161449.1
(22) Date of filing: 04.03.2025
(51) Int. Cl.: H05K 3/24, H05K 3/34, H05K 3/28, H05K 3/26

(54) **COMPONENT CARRIER, METHOD FOR MANUFACTURING A COMPONENT CARRIER AND A PACKAGE COMPRISING A COMPONENT CARRIER**

(30) Priority: 27.03.2024 CN 202410361283
(71) Applicant: AT & S Austria Technologie & Systemtechnik Aktiengesellschaft, 8700 Leoben-Hinterberg (AT)
(72) Inventor: TSAI, Tim, Chongqing, 400021 (CN); IBRAHIM, Azmi, 31450 Tambun (MY); DONG, Kevin, Chongqing, 400060 (CN)
(74) Representative: Donatello, Daniele

(57) **Abstract**

The present invention relates to a component carrier (100) comprising a stack (10), a manufacturing method for a component carrier (100) and a package comprising a component carrier (100), wherein said stack (100) comprises an electrically conductive layer structure (11), and a solder resist layer structure (14), wherein said electrically conductive layer structure (11) and said solder resist layer structure (14) being arranged in a stacking direction (Z). Said solder resist layer structure (14) comprises at least one opening (17) by which a portion (18) of the at least one electrically conductive layer structure (11) is exposed, wherein at least on a part of said exposed portion (18) of the at least one electrically conductive layer structure (11) at least one protective layer structure (12) is provided. Said protective layer structure (12) comprises an at least substantially plate-shaped central portion (12A) having a first thickness distribution (dcp = f (X, Y)) and an at least substantially wall-shaped peripheral portion (12B) having a second thickness distribution (dpp = f (hw, X, Y)). Said central portion (12A) is at least partially in contact with the exposed portion (18). Said peripheral portion (12B) is at least partially provided at an external side of the central portion (12A) and extends least partially in a direction (hw) different from a plate extension direction (X, Y) of the central portion (12A, B), wherein the first thickness distribution (dcp = f (X, Y)) is different from the second thickness distribution (dpp = f (hw, X, Y)).

## Description

### FIELD OF THE INVENTION

The present invention generally relates to a component carrier comprising a stack, wherein the stack comprises at least one electrically conductive layer structure, and a solder resist layer structure. The at least one electrically conductive layer structure and the solder resist layer structure are arranged, in particular stacked, in a stacking direction. The solder resist layer structure comprises at least one opening by which a portion of the at least one electrically conductive layer structure is exposed. At least on a part of said exposed portion of the at least one electrically conductive layer structure at least one protective layer structure is provided. Further, the present invention relates to a method for manufacturing such a component carrier. Additionally, the present invention relates to a package comprising a component carrier.

### TECHNICAL BACKGROUND

Component carriers as mentioned above are in general well-known. Also, methods for manufacturing of such component carriers and assemblies or packages comprising such a component carrier are known in general.

Driven by increasing miniaturization and increasing packing density of electronic components on the component carriers, the requirements for accuracy and tolerances to be adhered to, in particular during manufacturing, are increasing in order to remain the risk of malfunctions or failures low over lifetime of the component carrier.

It is in particular a challenge to provide a component carrier with connection portions having proper dimensions to assure a good electrical connection, avoiding at the same time defects coming by the short distances between there portions, potentially causing electric shorts.

For the wide range of possible defects and defect patterns, various measures are known from prior art to reduce the risk of their occurrence in a life of a component carrier.

Against this background, the technical problem underlying the present invention is to provide an alternative, in particular an improved, component carrier, an alternative, in particular improved, method for manufacturing such a component carrier, and an alternative, in particular improved, package comprising a component carrier, by which in particular the above described challenge is faced and preferably the risk of occurring defects can be reduced, more preferably with as little additional effort as possible and/or without significant disadvantages.

### SUMMARY OF THE INVENTION

With respect to the above, a component carrier, a method for manufacturing thereof and a package comprising a component carrier according to the respective independent patent claims are provided. Advantageous embodiments of the present invention are defined by the dependent patent claims, the description, and the figures. The wording of the claims is hereby made part of the description by express reference.

According to a first aspect of the present invention, a component carrier is provided, wherein the component carrier comprises a stack, and wherein said stack comprises at least one electrically conductive layer structure, and a solder resist layer structure. Said at least one electrically conductive layer structure and said solder resist layer structure are arranged, in particular stacked, in a stacking direction, wherein said solder resist layer structure comprises at least one opening by which a portion of the at least one electrically conductive layer structure is exposed. At least on a part of said exposed portion of the at least one electrically conductive layer structure at least one protective layer structure is provided. Said protective layer structure comprises an at least substantially plate-shaped central portion having a first thickness distribution and an at least substantially wall-shaped peripheral portion having a second thickness distribution. Said central portion is at least partially in contact with the exposed portion, and said peripheral portion is at least partially provided at an external side of the central portion. The peripheral portion is at least partially extending in a direction different from a plate extension direction of the central portion. The first thickness distribution is different from the second thickness distribution. Alternatively, the first thickness distribution may be the same with the second thickness distribution if the thickness does not impact the opening size for accommodating at least one interconnection structure such as bump/pillar.

With this design of a component carrier, in particular with the specific design and arrangement of the protective layer structure provided, the risk of occurrence of malfunctions and/or failure over lifetime of a component carrier can be reduced, assuring at least in some cases at the same time a good compromise with larger conductive areas due to the peripheral portion in addition to the central portion of the protective layer structure. Meanwhile such design may provide a wider window for the manufacturing process, which improves the yield and reduces the production cost.

By the design of the protective layer structure according to the invention, in particular a subsequent soldering process can be improved, in particular due to the peripheral portion specific extension. By the presence of a protective layer structure according to the present invention, a more reliable soldering process can be enabled. The more the component carrier size is reduced, in particular the smaller the openings (of the solder resist layer structure) become, the more this design is advantageous since with increasing miniaturization manufacturing becomes more difficult and has to be more precise, however of course only until a certain degree of miniaturization. The inventive design of the component carrier and the method for manufacturing such a component carrier for achieving the inventive design contribute to the advantage of controlling the accuracy of product features within defined tolerances in a stable manner to ensure the electrical performance of interconnections with interconnection structures and components the component carrier is to be connected with later on.

Another advantage is that a component carrier according to the present invention may be manufactured using established component carrier manufacture technology. Its manufacturing can directly be implemented into existing production lines without significant efforts or disadvantages. What is more is that the invention provides an efficient and compared low-cost solution.

In the context of the present application, the term "component carrier" may particularly denote any support structure which is capable of accommodating one or more components thereon and/or therein for providing mechanical support and/or electrical connectivity. A component carrier may also support thermal management, wherein the component carrier may in particular serve as a heat guiding and/or conduction structure, preferably supporting heat dissipation. In other words, a component carrier may be configured as a mechanical and/or electronic and/or thermal (acting) carrier for components.

In particular, a component carrier may be one of or may be configured as a printed circuit board (PCB), an interposer, in particular an organic interposer, and an IC (integrated circuit) substrate. A component carrier may also be a hybrid board combining different ones of the above-mentioned types of component carriers.

A component carrier may in particular comprise one or more stacks and/or more than an electrically conductive layer structure, a solder resist layer structure and a protective layer structure, wherein the protective layer structure is at least applied to at least a part of at least one of the exposed portions of the electrically conductive layer structure. The protective layer structure may also be functionalized as an electrically conductive layer structure for at least one component.

In at least one embodiment, the component carrier may comprise in addition at least one further layer structure, as for example, at least one electrically insulating layer structure.

In at least one embodiment, the component carrier is in particular a laminate-type component carrier. In such an embodiment, the component carrier may in particular be a compound of multiple layer structures which are stacked and connected together by applying a pressing force and/or heat, in particular with simultaneous application of vacuum.

In the context of the present application, the term "component" may particularly denote an electronic component which is configured to be mounted on and/or to be embedded into a component carrier, wherein the component may further in particular be configured to be electrically connected to the component carrier. A component can be an inorganic component (such as, for example, a semiconductor component) or a component comprising inorganic material and/or metal material and/or a combination thereof or consisting thereof.

The at least one component may in particular be selected from a group consisting of: an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminum oxide (Al2O3) or aluminum nitride (AIN). In order to increase the heat exchange capacity, other geometries with increased surface area are frequently used as well. Further-more, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga2O3), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, in addition or alternatively, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In the context of the present application, the term "stack" may particularly denote an arrangement of multiple planar layer structures which are mounted in parallel on top of one another. Some of the layer structures of the stack described herein may be stacked directly onto each other, that means with not further layer structure or component in between or indirectly, wherein between other layer structures described in the present application, further layer structures or components or the like may be arranged which are not described in the present application unless explicitly described to the contrary.

In the context of the present application, the term "stacking direction" my particularly refer to a direction perpendicular to a planar extension of at least one layer structure of the stack.

In the context of the present application, the term "layer structure" may particularly denote a continuous layer, a patterned layer or a plurality of non-consecutive islands within a common plane. A layer structure can comprise at least one protruding element such as, for example, one or more solder bumps, copper bumps, pillars or other bonding structures like these, wherein the at least one protruding element may in particular protrude beyond the surface of a layer structure.

In at least one embodiment, at least one body and/or layer structure of the component carrier comprises a main surface, wherein in the context of the present application, the term "main surface" of a body or a layer structure may particularly denote one of the two largest opposing surfaces of the body or the layer structure or the outermost layer (structure) of the component carriers. The main surfaces may be connected by circumferential side walls. The thickness of a body or a layer structure, such as a stack, may be defined by the distance between the two opposing main surfaces, in particular in direction perpendicular to the extension of the main surface, in particular perpendicular to its planar extension.

In the context of the present application, the term "electrically conductive layer structure" may particularly denote a layer structure which is electrically conductive. An electrically conductive layer structure may in particular comprise one or more conductive pathways, tracks, and/or signal traces and/or through connections such as vias and holes and/or interconnection structures for interconnection of the layers and/or for connection with other elements and/or components such as bumps, pillars or the like. These electrically conductive structures may for example be etched from copper sheets and may, for example, be laminated onto an electrically non-conductive or electrically insulating layer structure, which in at least one embodiment the component carrier may comprise additionally.

In at least one embodiment, the at least one electrically conductive layer structure of the component carrier comprises at least one of the following group consisting of: copper, aluminum, nickel, silver, gold, palladium, tungsten and magnesium and/or an alloy comprising at least one material component of the aforementioned group. Although copper is usually preferred, other materials or coated versions thereof are possible as well, in particular coated with supra-conductive material or conductive polymers, such as graphene or poly(3,4-ethylenedioxythiophene) (PEDOT), respectively.

In the context of the present application, the term "solder resist layer structure" may particularly denote a layer structure which may also be named as "solder mask" and which may in particular be applied to a surface of another layer structure, in particular to a main surface of said other layer structure, to prevent solder from adhering to unintended areas of said surface of said other layer structure during the soldering process. Thus, ensuring that solder is applied only to designated areas, as for example to designated solder pads, but not on the spaces in between these designated areas.

In at least one embodiment, the solder resist layer structure may be an electrically insulating solder resist layer structure. In at least one embodiment, the solder resist layer structure may be applied to a main surface of an electrically conductive layer structure, wherein the solder resist layer structure may in particular be applied to the outmost main surface of the at least one electrically conductive layer structure of a component carrier. The solder resist layers structure may be applied to one or both opposing main surfaces of a layer structure or a stack, wherein the solder resist layer structure may in particular be applied to the outmost main surfaces of the layer structure or the stack. The solder resist layer structure may be applied in terms of or by surface treatment. The solder resist layer structure may also act as a permanent protective layer to protect the circuit pattern from dust, heat, and moisture as well as insulating the component carrier's circuitry. The solder resist layer structure may also protect from mechanical influences, for example scratches.

In at least on embodiment, the solder resist layer structure may be formed by applying the solder resist layer structure onto an entire main surface of a layer structure to be covered first, and then subsequently pattern the solder resist layer structure so as to expose one or more surface portions of the layer structure coated by the solder resist layer structure before. The solder resist layer structure may in particular be applied onto an entire main surface of an outmost electrically conductive layer structure of a component carrier first, and then subsequently be patterned so as to expose one or more electrically conductive surface portions of the electrically conductive layer structure coated by the solder resist layer structure before. Thereby, at least one opening in the solder resist layer structure may be formed, wherein at least one opening may be delimited by at least one lateral wall of said solder resist layer structure, wherein at least one lateral wall particularly limits the opening in a lateral or transversal direction to the stacking direction.

In the context of the present application, the "exposure of at least one electrically conductive layer structure by at least one opening of the solder resist layer structure" may in particularly denote that said electrically conductive layer structure is exposed with respect to the surface of the solder resist layer structure opposed to the respective surface facing and/or being in contact with the electrically conductive layer structure, wherein said exposed portion of said at least one electrically conductive layer structure may in particular not be exposed to the external side of the stack, in particular not to the external side of the component carrier, as this may be completely covered by at least one further layer structure composing the stack, in particular by the at least one protective layer structure.

The at least one exposed portion of the electrically conductive layer structure of the component carrier may in particular be configured or may be used for electrically coupling of the component carrier to an electronic periphery. The remaining portions of said (partially exposed) electrically conductive layer structure - that means the unexposed surface portions - are preferably covered by the solder resist layer structure and may therefore be named as covered surface portions. By the solder resist layer structure, the covered surface portions, in particular (unexposed) surface portions containing copper, may efficiently be protected against oxidation or corrosion. Thereby, a component carrier may be provided which is configured for being electrically coupled to an electronic periphery by using one or more of the exposed surface portions of the main surface of an electrically conductive layer structure, wherein the remaining portions of said electrically conductive layer structure remains covered by the solder resist layer structure and therewith efficiently protected against oxidation or corrosion, which applies in particular for surface portions containing copper.

In the context of the present application, the term "protective layer structure" may in particular denote a layer structure which can be considered as a "surface finish layer structure" and which is in particular configured to prevent a surface, to which the protective layer structure has been applied to, from changing one or more of its characteristic properties within a defined timeframe under defined conditions.

A protective layer structure may in particular be, for example, a layer structure which may be applied to at least one exposed portion of an electrically conductive layer structure for the time being until an electric connection is established between the exposed portion and, for example, an electronic periphery. If an exposed surface portion of an electrically conductive layer structure is left unprotected, then the exposed electrically conductive layer structure material (in particular copper) might oxidize. This may result in a change of one or more characteristic properties of the electrically conductive layer structure in the zone of the exposed surface portion and making a component carrier with such an electrically conductive layer structure less reliable.

The protective layer structure has the function to protect the exposed electrically conductive layer structure (in particular copper circuitry) and enable a joining process, in particular reliable electrical connection process, with one or more components, for instance by soldering.

In at least one embodiment, at least one protective layer structure may be applied selectively to one or more exposed electrically conductive surface portions of an electrically conductive layer structure of the component carrier in terms of or by surface treatment.

A protective layer structure may comprise or be an electrically conductive cover material configured to be applied on exposed electrically conductive layer structures (such as pads, bumps, pillars, conductive tracks, etc., in particular comprising or consisting of copper) of a surface, in particular of an outmost and electrically conductive main surface of a component carrier. Examples for appropriate materials for protective layer structure material are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

A protective layer structure may be formed for instance as an interface or to act as an interface between a surface mounted component and the component carrier.

In the context of the present application, the term "electrically insulating layer structure" may denote a layer structure which is electrically non-conductive.

In at least one embodiment, the component carrier may further comprise an electrically insulating layer structure. In this case the at least one electrically insulating layer structure may comprise at least one of the following group consisting of: a resin or a polymer, such as epoxy resin, cyanate ester resin, benzocyclobutene resin, bismaleimidetriazine resin, polyphenylene derivate (for example based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, for example fibers impregnated with the above-mentioned resins, is called prepreg and may also be used. These prepregs are often named after their properties for example FR4 or FR5, which describe their flame-retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating layer structures.

In the context of the present application, the term "printed circuit board" (PCB) may particularly denote a component carrier, in particular a plate-shaped component carrier, which is preferably formed by laminating several layer structures, for instance by applying pressure and/or by the supply of thermal energy. A PCB in particular further comprises at least one insulating layer structure.

In at least one embodiment, in particular in a preferred embodiment of a PCB, the PCB is in particular formed by laminating several electrically conductive layer structures with several electrically insulating layer structures. The insulating layer structures may in particular be arranged in between the electrically conductive layer structures, wherein the electrically conductive layer structures and the insulating layer structures may be arranged alternating in stacking direction.

As preferred materials for PCB technology, the electrically conductive layer structures may be made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole may either connect the whole stack, (through-hole connections extending through several layers or the entire stack), or the filled hole may connect at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board may in particular be configured for accommodating one or more components on one or both opposing main surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier, in particular an IC substrate. An IC substrate may be, in relation to a PCB, a comparably small component carrier onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board. A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

A dielectric part of a substrate (of an IC substrate) may be composed of resin with reinforcing particles (such as reinforcing spheres, in particular glass spheres).

In the context of the present application, the term "interposer" may in particularly denote a physical structure configured to bridge at least one electrical connection. An interposer may in particular be a physical interface layer structure. An interposer may in particular be configured to spread an electrical connection to a wider pitch and/or to bridge between different connection types. An interposer can be made of various materials, including silicon, glass, or organic substrates. An IC substrate or interposer may in particular comprise or consist of an inorganic layer structure or at least a layer of glass, silicon (Si) and/or a photo-imageable or dry-etchable organic material like epoxy-based build-up material (such as epoxy-based build-up film) or polymer compounds (which may or may not include photo- and/or thermosensitive molecules) like polyimide or polybenzoxazole as electrically insulating material.

In the context of the present application, the term "central portion" may particularly denote a portion located near or at or around or adjacent a middle or a center area of a corresponding layer structure.

In the context of the present application, the term "at least substantially plate-shaped" may particularly denote a three-dimensional structure having an extension in a plate extension direction that is at least twice, in particular a multiple, of an extension of said structure in a direction perpendicular to the plate extension direction.

In the context of the present application the "plate extension direction" may in particular extend at least substantially parallel to the plate extension of the central portion and/or at least substantially parallel to one main surface of the stack and/or at least to one main surface of the at least one electrically conductive layer structure.

In the context of the present application, the term "peripheral portion" may particularly denote a portion located near or at or adjacent an outer area or an edge area of a corresponding layer structure or which at least partially surrounds the layered structure.

In the context of the present application, the term "at least substantially wall-shaped" may particularly denote a three-dimensional structure that resembles at least substantially the characteristics of a wall, in particular the extension in three dimensions which may, for example, be indicated by wall length, wall thickness or width, and wall height. A wall-shaped structure may in particular be characterized by having a relatively thin thickness compared to its other dimensions. In particular, at least the wall height and/or the wall length may have a dimension that is at least twice, in particular a multiple, of the wall thickness of said structure. The at least substantially wall-shaped peripheral portion may have at least partially a straight or a curved shape, over its wall-length and/or its wall-height, respectively.

In the context of the present application, the "wall height direction" may in particular extend in a direction different from the plate extension direction, in particular with an angle relatively to said plate extension direction. In at least one embodiment, the wall height direction may extend in a direction perpendicular to the plate extension direction. In a preferred embodiment, the angle between the plate extension direction and the wall height direction may be in a range from approx. 45° to 90°, in particular in a range from 80° or 85° up to 87°, 89°, 89,5°, 89,9° or 89,95°.

In the context of the present application, the term "thickness distribution" may particularly denote the variation in thickness across the extent of a layer structure.

Thus, a thickness distribution of the central portion, for example the first thickness distribution, may in particular refer to the variation in thickness across the extent of the central portion of the protective layer structure. The thickness distribution of the central portion may in particular be defined as a layer thickness profile along a defined plate extension direction.

Consequently, a thickness distribution of the wall-shaped peripheral portion, for example the second thickness distribution, may in particular refer to the variation in thickness across the extent of the wall-shaped peripheral portion of the protective layer structure, in particular to a thickness distribution of the variation of the wall thickness in wall height direction and/or wall length direction.

A different thickness distribution may particularly denote a different variation of the thickness along the extent of the respective central and/or peripheral portions and/or a different spatial (e.g., vertical) location of the thickness of the respective portions, for example on the at least one electrically conductive layer structure (as it for example may be the case for the central portion) and/or at a spatial location ( e.g. vertically) away from the at least one electrically conductive layer structure, in particular on the (opening of) the solder resist layer structure (as it may be for example the case for the peripheral portion).

In at least one embodiment, in particular in a preferred embodiment, the protective layer structure may cover the entire exposed portion of the electrically conductive layer within said least one opening in the solder resist layer, wherein the protective layer structure may in particular cover its outward facing surface. Thereby, the entire exposed surface of the electrically conductive layer structure may be protected, for example from oxidization. Thus, a change of one or more characteristic properties of the electrically conductive layer structure in the zone of the exposed surface portion may be prevented. As a result, a component carrier with a reliable exposed electrically conductive layer structure (in particular copper circuitry) may be provided, which may enable a joining process, in particular a reliable electrical connection process, with one or more components, for instance by soldering or sintering or other bonding structure.

Alternatively, the protective layer structure may only extend over a part of the exposed electrically conductive layer structure within an opening and therewith only cover a part of said exposed portion.

In at least one embodiment, in particular in a preferred embodiment, the central portion may monolithically merge into the peripheral portion. Thereby, a closed and uninterrupted transition from the central portion into the peripheral portion and vice versa may be realized and therewith an advantageous protection of the surface of the exposed portion of the electrically conductive layer structure. As a result, the risk of any oxidization or any other negative influence in and around a transition zone between the central portion and the peripheral portion may be reduced.

### #claim2#

In at least one embodiment of the present invention, in particular in an advantageous embodiment, the central portion extends at least partially planarly. The central portion may in particular be a substantially planar or planar plate-shaped central portion. An at least planar extension of the central portion allows providing a component carrier which allows in the area of the opening an easy and reliable electrically connection with the electrically conductive layer structure and/or providing an electrically conductive connection structure, for example at least one solder ball and/or copper bump.

### #claim3#

In at least one embodiment of the present invention, in particular in an advantageous embodiment, the central portion extends at least partially in a direction perpendicular to the stacking direction.

The central portion may in particular extend at least partially parallel to the exposed portion of the conductive layer structure, in particular parallel to the main surface of the exposed portion of the conductive layer structure. A bottom surface of the protective layer structure being in contact with the exposed portion of the electrically conductive layer structure may in particular extend at least partially parallel to the exposed portion. Thereby, a sufficient protection of the exposed portion can be achieved with minimum protective layer structure thickness and minimum amount of protective layer structure material.

### #claim4#

In at least one embodiment of the present invention, in particular in an advantageous embodiment, the peripheral portion of the protective layer structure extends at least partially in a direction inclined with respect to the plate extension of the central portion of the protective layer structure.

In at least one embodiment, the peripheral portion may extend inclined to the plate extension direction with an angle up to a substantially perpendicular extension direction (approx. 90°, but <90°) or a perpendicular extension direction. However, in a preferred embodiment, the angle between the plate extension direction and the wall height direction is in a range from approx. 45° to 90°, in particular in a range from 80° or 85° up to 87°, 89°, 89,5°, 89,9° or 89,95°. This may bring the advantage of increasing an interface area between the peripheral portion of the protective layer structure and the solder resist layer structure and thus may ensure reliable integration of the protective layer structure in the stack. Additionally or alternatively, this may bring the advantage of a higher conductive area exposed to the external side of the component carrier, decreasing the planar extension impact of the resulting protective layer structure. Besides that, this structure may in some cases allow to achieve an increased robustness of a corresponding manufacturing process. In some cases, also bigger tolerance ranges can be maintained for product production with target function and yield.

### #claim5#

In at least one embodiment of the present invention, in particular in an advantageous embodiment, the central portion has a constant thickness over the plate extension, in particular over the whole extension of the central portion. Thereby, a sufficient protection of the exposed portion can be achieved with minimum protective layer structure thickness and minimum amount of protective layer structure material.

In the context of the present application the term "constant thickness" may particularly denote a thickness distribution comprising thicknesses with substantially the same values, in particular with thickness values within a deviation ratio of less than 10 percent of the respective mean (arithmetic mean) thickness value. The constant thickness of the central portion can provide a good connection with components ( for example bumps) as the interface between the central portion and bumps has a maximum area of electrical connection so it can ensure the signal transmission path is broad enough.

### #claim6#

In at least one embodiment of the present invention, in particular in an advantageous embodiment, the peripheral portion has in particular a variable wall thickness, wherein the thickness of the peripheral portion is in particular decreasing in at least one wall direction away from the central portion. The thickness of the wall-shaped peripheral portion may in particular decrease such that it is substantially zero at an extremity of its wall height (at its free wall end). By the decrease of the thickness of the peripheral portion in at least one wall direction, wherein the wall-thickness preferably decreases over the wall-height, an advantageous behavior of the protective layer structure may be achieved with respect to at least one subsequent process step. Additionally or alternatively, this may bring the advantage that undue electrical connections of said protective layer structure with adjacent conductive structures are prevented, due to the thin and precise shaping of the external profile of the peripheral portion.

### #claim7#

In at least one embodiment of the present invention, in particular in an advantageous embodiment, the peripheral portion of the protective layer structure extends at least partially (preferably completely) along a circumference of the central portion of the protective layer structure, in particular such that the peripheral portion surrounds the central portion at least partially (preferably completely) along the circumference of the central portion. Thereby, a partial, an intermittent or closed and uninterrupted transition from the central portion into the peripheral portion and vice versa may be realized in a circumferential direction and therewith an advantageous protection of the surface of the exposed portion of the electrically conductive layer structure can be achieved. As a result, the risk of any oxidization or any other negative influence in and around a transition zone between the central portion and the peripheral portion can be reduced.

### #claim8#

In at least one embodiment of the present invention, in particular in an advantageous embodiment, the stack, in particular the solder resist layer structure, comprises at least one external surface, in particular at least one external main surface. At least on a lateral wall of the solder resist layer structure delimiting at least one opening may be part of at least one external surface of the stack.

### #claim9#

In at least one embodiment of the present invention, in particular in an advantageous embodiment, the at least one opening of the solder resist layer structure is delimited by at least one lateral wall, and at least one portion of the peripheral portion of the protective layer structure (in particular an outer wall surface) extends at least substantially parallel, in particular along, the lateral wall of the opening in the solder resist layer structure.

In a preferred embodiment, the peripheral portion follows at least partially the shape of the lateral wall of the solder resist layer structure which delimits the opening by which the electrically conductive layer structure is exposed. This may lead to a safer protection of the exposed portion of the electrically conductive layer structure, in particular if the peripheral portion of the protective layer structure is extending beyond the exposed portion, in particular overlapping, at least partially, the solder resist layer structure. This product feature may indicate the use of the related manufacturing process and thus may ensure a low-scrap production of the component carrier.

The lateral wall of the solder resist layer structure may have an at least partially inclined and/or rounded lateral wall, in particular if the opening is made by drilling, in particular by laser drilling, what is preferred. However, the opening may in general also be formed by a different manufacturing process.

### #claim10#

In at least one embodiment of the present invention, in particular in an advantageous embodiment, the peripheral portion of the protective layer structure contacts at least partially the solder resist layer structure, in particular at at least one lateral wall delimiting the opening in the solder resist layer structure, wherein in particular the peripheral portion contacts at least one lateral wall delimiting the opening in the solder resist layer structure with one of its wall surfaces (preferably with an/the outer wall surface which is) facing away from the central portion.

By a peripheral portion following the shape of the lateral wall of the solder resist layer structure delimiting said opening, in particular if the peripheral portion contacts the lateral wall at least partially over its height in wall-height direction (preferably completely) an advantageous (in particular a complete) coverage of the exposed portion can be achieved and therewith an advantageous protection of the exposed portion.

In addition to the at least substantially plate-shaped central portion and the at least substantially wall-shaped the peripheral portion may further comprise at least one additional portion. This additional portion may in particular be monolithically merged with the wall-shaped peripheral portion downstream, respectively at an end of the wall-shaped peripheral portion which is facing away from the central area. Said additional peripheral portion may extend at least partially in a direction parallel to a main surface of the solder resist layer structure, wherein a bottom surface of said additional portion may at least partially cover, and in particular contact, the external and free main surface of the solder resist layer structure, in particular in a zone adjacent to a free edge of the solder resist layer structure. In other words: The peripheral portion may extend along the external main surface of the solder resist layer structure, which is not in contact with the stacked layers. Thereby, a full and complete coverage of the exposed portion of the electrically conductive layer structure can be achieved. The size of the additional portion mentioned above may in particular be strictly controlled during manufacturing, in particular during performing a method according the second aspect of the invention, to avoid an overplating which might cause short of the product. That means the capability of the process is improved.

In at least one embodiment, in particular in a preferred embodiment, the wall-height of the wall-shaped peripheral portion does not exceed the height or thickness of the solder resist layer structure at its lateral wall delimiting the opening by which the electrically conductive layer structure is exposed. In other words: The peripheral portion may (only) extend along the inner lateral wall delimiting the opening in the solder resist layer structure of said stack. The peripheral portion may (only) be in contact with the solder resist layer structure of said stack at the inner lateral wall delimiting the opening in the solder resist layer structure of said stack.

### #claim11#

In at least one embodiment of the present invention, in particular in an advantageous embodiment, a distance between an upper wall extremity of the peripheral portion and a closest point on the upper edge of the lateral wall delimiting the opening in the solder resist layer structure and being contacted by the peripheral portion is constant, in particular within a deviation of 10 percent. In a preferred embodiment, this applies at least partially in circumferential direction of the peripheral portion, in particular along the complete circumference. This product feature may indicate the use of the related manufacturing process and thus may ensure that the protective layer structure is in particular provided in the opening only (and preferably not protruding out of the external main surface).

### #claim12#

In at least one embodiment of the present invention, in particular in an advantageous embodiment, the extremity of the peripheral portion contacts the solder resist layer structure at its lateral wall with a contact angle of at least 90 degrees, preferably with a contact angle greater than 90 degrees. This may in particular be achieved by a hydrophobic property of the external surface of the solder resist layer, in particular by a hydrophobic property of the lateral wall. A contact angle >90 degrees results in an undercut on the extremity of the peripheral portion. With a contact angle of at least 90 degrees, preferably with a contact angle greater than 90 degrees, an advantageous behavior of the protective layer structure may be achieved with respect to a subsequent process step, in particular avoiding undue planar surface expansions of said protective layer structure toward other eventual conductive layer structures.

### #claim13#

In at least one embodiment of the present invention, in particular in an advantageous embodiment, a roughness in the area of the central portion of the bottom surface of the protective layer structure facing towards the conductive layer structure is higher than a roughness in the area of the peripheral portion of an outer lateral surface of the peripheral portion facing towards the lateral wall of the solder resist layer structure. This applies in particular at the surface of the peripheral portion in contact with the solder resist. The higher roughness in the area of the central portion of the bottom surface of the protective layer structure facing towards the conductive layer structure may ensure an advantageous, in particular a reliable adhesion of the protective layer structure to the conductive layer structure.

### #claim14#

In at least one embodiment of the present invention, in particular in an advantageous embodiment, the protective layer structure comprises at least one protecting conductive layer structure or is a protecting conductive layer structure, wherein said conductive protective layer structure may in particular cover the entire opening, preferably the entire electrically conductive layer within the opening. Thereby, despite the presence of a protective layer structure covering the exposed portion of the electrically conductive layer structure, in an easy manner an electric connection with said electrically conductive layer structure can be established, in particular without removing the protective layer structure before establishing electrical connections.

### #claim15#

In at least one embodiment of the present invention, in particular in an advantageous embodiment, the protective layer structure, in particular both the central portion and the peripheral portion, define(s) an external surface configured to act as a guiding structure for a solder material to be flowed and electrically connected to the exposed surface. By the guiding structure resulting from the peripheral portion and the central portion, a subsequent electrical connection process, in particular a subsequent soldering process, may be improved.

### #claim16#

In at least one embodiment of the present invention, in particular in an advantageous embodiment, the guiding structure comprises a basin-like shape or a basin shape, wherein the bottom of the basin is in particular formed by the plate-shaped central portion and the wall of the basin by the wall-shaped peripheral portion of the protective layer structure. Thereby, a further improvement of a subsequent electrical connection process, in particular of a subsequent soldering process may be achieved, since the basin-like shape, resulting from the peripheral portion extending along a different direction than the plate extension direction, may be configured as spatial boundary and may prevent solder material from direct contact with the solder resist layer structure.

### #claim17#

In at least one embodiment of the present invention, in particular in an advantageous embodiment, the peripheral portion forms a protrusion which protrudes beyond the central portion in the stacking direction away from the exposed surface of the conductive layer structure. Said protrusion may act in a beneficial manner with following process steps, for example a solder process, and therefor may enable highly reliable electrical and/or mechanical connections.

### #claim18#

In at least one embodiment of the present invention, in particular in an advantageous embodiment, the protective layer structure is a multilayer structure. The multilayer structure may enable to modify the total physical and/or chemical properties, which a protective layer structure consisting of one layer may not be capable of.

### #claim19#

In at least one embodiment of the present invention, in particular in an advantageous embodiment, the protective layer structure comprises a layer made of nickel (Ni), and/or a layer made of palladium (Pd) and/or a layer made of gold (Au). In another embodiment the protective layer structure may comprise a layer made of an alloy, in particular an alloy comprising nickel, palladium and/or gold. In an example, nickel may be located such that it is sandwiched between the electrically conductive layer structure and palladium and/or gold. This may have the advantage that palladium or gold may act as protective material against oxidation whereas nickel may be configured as an adhesion promotor and/or diffusion barrier. Thus, the protective layer structure may enable reliable solder connection and good electrical connection

### #claim20#

In at least one embodiment of the present invention, in particular in an advantageous embodiment, the material respectively the composition, of the protective layer structure being in contact with the exposed electrically conductive layer structure is different from that of said electrically conductive layer structure. The protective layer structure may comprise at least one material component which may be the same as at least one material component of the electrically conductive layer structure, but preferably the protective layer structure has a composition different to the composition of the electrically conductive layer structure. Thus, the material of the protective structure may act as a protection against the environment, for example air or moisture, and thus may have better material properties compared to the electrically conductive layer structure, which ensures a reliable connection, for example by soldering.

### #claim21#

In at least one embodiment of the present invention, in particular in an advantageous embodiment, a plurality of openings is provided in the solder resist layer structure, each of said openings exposing a portion of the at least one electrically conductive layer structure. This enables a plurality of contact zones for electrical connections of the at least one electrically conductive layer structure with an electronic periphery.

### #claim22#

In at least one embodiment of the present invention, in particular in an advantageous embodiment, the peripheral portion of the protective layer structure provided on the exposed portion is distanced from a further peripheral portion of a further protective layer structure provided on a further exposed portion being arranged adjacent, wherein said peripheral portion is in particular distanced at least of 1 µm, 3 µm or 5 µm, and in particular up to 10 µm, from said further peripheral portion. Said peripheral portion is in particular distanced in a range from 5 µm to 10 µm from said further peripheral portion. Thereby the risk of short circuits and/or other defect patterns may be reduced.

### #claim23#

In at least one embodiment of the present invention, in particular in an advantageous embodiment, the component carrier, in particular the stack, further comprises at least one electrically insulating layer structure, wherein said electrically insulation layer may in particular be arranged, in particular stacked, with said electrically conductive layer structure and/or said solder resist layer in stacking direction.

In at least one embodiment, the component carrier may further comprise at least one inorganic layer structure, wherein said at least one inorganic layer structure may in particular be part of at least one stack of said component carrier. The use of at least one electrically insulating layer structure, in particular an inorganic layer structure may enhance the possibility and/or flexibility of component carrier design and thus may enable realization of more complex structures.

In the context of the present application, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass, for example silicon base glass, in particular solder lime glass, and/or boro-silicate glass and/or alumo-silicate glass and/or lithium silicate glass and/or alkaline free glass. In another example, the inorganic layer structure may comprise ceramic material, for example aluminum nitride and/or aluminum oxide and/or silicon nitride and/or boron nitride and/or tungsten comprising ceramic material. Yet, in another example, the inorganic layer structure may comprise semi-conducting material, for example silicon and/or germanium and/or silicon oxide and/or germanium oxide and/or silicon carbide and/or gallium nitride. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above-mentioned example, such as: MoS2, CuGaO2, AgAlO2, LiGaTe2, AgInSe2, CuFeS2, BeO.

### #claim24#

A method for manufacturing a component carrier according to the second aspect of the present invention comprises at least the following steps:
a) forming a stack, said stack at least comprising:
   at least one electrically conductive layer structure, and
   a solder resist layer structure;
      wherein said at least one electrically conductive layer structure and said solder resist layer structure are being arranged, in particular stacked, in a stacking direction;
      wherein said solder resist layer structure comprises at least one opening by which a portion of the at least one electrically conductive layer structure is exposed,
b) providing at least on a part of said exposed portion of the at least one electrically conductive layer structure at least one protective layer structure;
   wherein said protective layer structure being provided comprises an at least substantially plate-shaped central portion having a first thickness distribution, and an at least substantially wall-shaped peripheral portion having a second thickness distribution,
   wherein said protective layer structure is being provided such that:
      said central portion is provided at least partially in contact with the exposed portion; and
      said peripheral portion is provided at least partially at an external side of the central portion and being at least partially extending in a direction different from a plate extension direction of the central portion; and
      wherein the first thickness distribution is different from the second thickness distribution.

By using a method according to the second aspect of the present invention for manufacturing a component carrier, a component carrier can be provided, by which the risk of occurrence of malfunctions and/or failure over lifetime of a component carrier can be reduced. By the design of the protective layer structure according to the invention in particular a subsequent soldering process can be improved, in particular its outcome. By the presence of a protective layer structure according to the present invention, a more reliable soldering process can be enabled. The more the component carrier size is reduced, in particular the smaller the openings become, the more this design is advantageous since with increasing miniaturization manufacturing becomes more difficult and has to be more precise, however of course only until a certain degree of miniaturization. The provided method allows to use established component carrier manufacture technology and can directly be implemented into existing production lines without significant efforts or disadvantages.

In at least embodiment, the stack is formed such that the resulting stack, in particular the solder resist layer structure, comprises at least one external surface.

In at least one embodiment, additionally at least one further layer structure may be provided, in particular at least one electronically insulating layer structure.

After having completed formation of a stack, a surface treatment of the obtained layer structures or component carrier, in particular of at least one external surface of said stack, may be performed (partially or completely).

In at least one embodiment, the protective layer structure may be provided by ENIG (Electroless Nickel Immersion Gold) plating and/or ENEPIG (Electroless Nickel Electroless Palladium Immersion Gold) plating. ENIG and ENEPIG are generally known surface finishing processes used in the manufacturing of printed circuit boards (PCBs). These surface finish or surface protection processed serve to protect the underlying copper from oxidation and to provide a solderable surface and may at least partially form protective layer structures.

ENIG is a two-layer metallic coating of electroless nickel under a layer of immersion gold. The nickel acts as a barrier to the copper and is the surface to which the solder adheres, while the gold protects the nickel during storage and provides a low resistance contact surface.

ENEPIG, on the other hand, includes an additional layer of electroless palladium between the nickel and gold layers. This palladium layer offers several benefits, including acting as a barrier to prevent nickel from diffusing into the gold layer, which can cause solderability issues. ENEPIG is inter alia known for its excellent solderability.

### #claim25#

In at least one embodiment of the present invention, the method may comprise a further step, which is in particular performed before providing the at least one protective layer structure on said exposed portion, wherein said further step in particular comprises a surface treatment.

The surface treatment may be applied to the whole external surface of the stack or to parts thereof, wherein in particular the at least one exposed portion of the electrically conductive layer structure and/or the external surface of the solder resist layer structure are subject to the surface treatment.

In at least one embodiment, the surface treatment may comprise one or more treatment steps, wherein such a treatment step may be applied to the whole external surface of the stack or only to one or more parts or portions thereof. That means in other words, that one or more treatment steps, e.g., may be applied only to the solder resist layer structure or parts thereof, but e.g., not to one or more of the at least one exposed portions, or vice versa. However, in one or more other treatment steps, e.g., both the solder resist layer structure or parts thereof and at least one exposed portion may be subject to the respective treatment.

In at least one embodiment, the surface treatment may comprise a cleaning and/or degreasing step, in particular for removing contaminants such as oils, grease, and dirt from the surface, preferably at least of the surface of the exposed portion of the electrically conductive layer structure. Thereby, adhesion of the later applied protective layer structure may be improved. For cleaning alkaline or acidic solutions may be used, depending on the type of material and contaminants, wherein immersion, spraying, or ultrasonic cleaning methods may be used. Cleaning may comprise a thoroughly rinsing process to remove any residual cleaning agents, wherein for rinsing, for example, deionized water may be used.

In at least one embodiment, the surface treatment may comprise a micro etching and/or surface roughening step, in particular at least of the surface of the exposed portion of the electrically conductive layer structure, for increasing the surface area and generation of a rougher surface profile, enhancing mechanical adhesion of the later applied protective layer structure. For lightly etching the surface, for example, an acid solution (in particular containing sulfuric acid and hydrogen peroxide), may be used.

In at least one embodiment, the surface treatment may comprise a surface activation step for activating the surface, in particular oat least of the surface of the exposed portion of the electrically conductive layer structure. Surface activation may comprise plasma treatment or any other appropriate kind of surface treatment.

In at least one embodiment the surface activation may comprise a treatment with a palladium (Pd) activator solution, in particular to form an activation layer in preparation for the step of providing the protective layer later on. By the palladium in the activator solution the subsequent electroless nickel plating may be catalyzed by providing nucleation sites for nickel deposition.

If palladium and/or nickel and/or gold has not only deposited on the surface of the exposed portion, but also on the surface of the solder resist layer structure, performing a (further) treatment of the stack, in particular of the solder resist layer structure, may be advantageous or in some cases necessary.

Hence, in at least one embodiment of the method according to the second aspect of the invention, in particular if palladium and/or nickel and/or gold is deposited at least in defined zones of the solder resist layer surface, the surface treatment may comprise a treatment step for surface treatment of the solder resist layer structure, in particular of at least a part (in particular at least of some or all of the defined zones) of the solder resist layer structure. In another embodiment, the complete solder resist layer structure may be a subject to surface treatment. Therefore, in an advantageous embodiment of the present invention, the deposition of palladium and/or nickel and/or gold can preferably accurately be controlled during the process to ensure good electrical performance of the product.

In at least one embodiment, the surface treatment may in particular comprise a surface treatment of the solder resist layer structure for removal of palladium and/or nickel and/or gold, which has been applied to the solder resist layer structure in the activation step at least partly from the surface of the solder resist layer structure. In particular, the palladium may be removed (in particular at least) in an edge area adjacent to the lateral wall of the solder resist layer structure from the solder resist layer structure. Preferably, the activation layer, in particular the palladium, remains on the surface of the exposed portion of the electrically conductive layer structure to ensure proper application of the protective layer structure later on.

By a surface treatment of the solder resist layer structure before providing the protective layer structure, the later performed method step of providing the protective layer structure can be influenced advantageously. In particular, process reliability and process quality of providing the protective layer structure can be improved. In particular, accuracy of the protective layer structure (in particular with respect to shape and/or dimension), and/or process quality (and/or stability) may be increased. Thereby overall, for example, particularly the failure rate due to overplating defects (caused by overplating of the protective layer) may be reduced. The surface treatment step in particular helps to ensure proper adhesion and/or corrosion resistance of the surface finish (i.e., of providing the protective layer structure). With a proper surface treatment process, a reliable surface finish may be enabled by which the stringent requirements of electronic components may be fulfilled.

### #claim26#

In at least one embodiment, with a surface treatment in particular a surface characteristic of the solder resist layer structure is changed, in particular of at least one external surface of the solder resist layer structure, preferably of at least one lateral wall and/or external main surface of the solder resist layer structure. By changing the surface characteristic of the solder resist layer structure, adhesion of the protective layer structure on the solder resist layer can be influenced, in particular reduced, whereby the risk and/or manifestation of overplating can be reduced.

For the change of the surface characteristic, for example, palladium (Pd) deposited on the solder resist layer structure may in particular be at least partially (in particular substantially completely) removed from the solder resist layer structure surface. Thereby, no or not enough palladium is available on the surface of the solder resist layer structure for catalyzing electroless nickel plating in a subsequent ENIG or ENEPIG process. Due to the absence of palladium no nucleation sites for nickel deposition are provided. Thereby, the risk of overplating of the protective layer material onto the solder resist layer structure can effectively be reduced. What is more is that the size of the protective layer can at least in some cases be controlled in an accurate manner to meet the specifications of the final package of IC.

### #claim27#

In at least one embodiment, the surface treatment of the external surface of the solder resist layer structure comprises a change of the surface tension and/or surface energy of its external surface. Thereby, adhesion of the protective layer structure on the solder resist layer can be influenced, in particular reduced, whereby the risk and/or manifestation of overplating can be reduced. In particular, wetting of the surface layer by the protective layer structure can be reduced. Thus, the risk for unwanted overplating of the solder resist layer structure by the protective layer structure can be reduced.

For the change of the surface tension and/or the surface energy of the external surface of the solder resist layer structure (at least in parts), for example palladium (Pd) deposited on the solder resist layer structure may in particular be at least partially (in particular substantially completely) removed from the solder resist layer surface. Removal of palladium from the external solder resist layer surface causes a change in polarity of the surface resulting in a change of the surface tension of the surface of the solder resist layer structure.

### #claim28#

In at least one embodiment, the change of the surface tension is configured to impart a hydrophobicity to the external surface of the solder resist layer structure. Thereby, adhesion of the protective layer structure on the solder resist layer can be influenced, in particular reduced, whereby the risk and/or manifestation of overplating can be reduced. In particular, a wetting capability of the surface layer for the protective layer structure can be reduced by providing a hydrophobic surface of the solder resist layer structure instead of a hydrophilic surface. Thus, the risk for unwanted overplating of the solder resist layer structure by the protective layer structure can be reduced.

By sufficient removal, for example, of palladium (Pd) deposited on the solder resist layer structure, a change in polarity of the surface can be achieved, resulting in a change of the surface tension of the surface of the solder resist layer structure such that the surface characteristic changes from hydrophilic to hydrophobic. As a result, the wetting capability decreases for the protective layer material. Thereby, the risk of overplating of the protective layer material onto the solder resist layer structure can effectively be reduced.

### #claim29#

A package according to the third aspect of the present invention, comprises at least one component carrier according to the first aspect of the present invention and/or at least one component carrier manufactured by a method according to the second aspect of the invention and at least one further part, being assembled with the component carrier.

In the context of the present application, the term "package" may particularly denote a setup or unit that integrates a component carrier and at least one further part.

In the context of the present application, the term "further part" may particularly denote any part which is being configured for forming a package together with at least one component carrier. This may include other hardware, software, or mechanical parts to form a functional package or assembly or device or a module of a larger system.

In at least one embodiment, the package is an electronic package or assembly. The package may comprise at least one component, in particular at least one electronic component.

A package may be, for example, an electronic circuit board comprising at least one component carrier and at least one further part, wherein one or more further parts may be formed by components being electrically connected (to each other and/or with the component carrier). A package may be, for example, an electronic module, an electronic device or any sub-assembly for an electronic device, comprising at least one component carrier and at least one further part.

A package may particularly denote a device providing an electronic functionality and being composed of a plurality of electrically, mechanically and/or thermally interconnected electronic constituents, such as a component carrier, one or more electronic components and/or active portions, etc..

A package can also provide one or more routing layers to fan out or fan in at least one an electrical connection from at least one component with in/out for establishing a connection, in particular an electrical connection, with at least one other element. Additionally, a package may provide a protection (e.g. a protection carrier) for protecting and/or mounting and/or sealing one or more components (such as, for example, one or more ICs). A package may be or may comprise a 2D, 2.5D, 3D type of package for different final applications and/or depending on the final application. A package may also comprise one or more (embedded) components (which may in particular be embedded in the wafer or PCB) or which may be mounted on the surface or on the PCB).

Examples for electronic devices are smartphones, computers and laptops, televisions and monitors, wearable devices (like ,e.g., smartwatches and/or fitness trackers), home devices (such as, e.g., microwave ovens, refrigerators, and washing machines), medical devices (like, e.g., blood glucose meters and portable ultrasound machines), electronic devices for the automotive industry (like, e.g., ECUs for engine management, infotainment systems, safety systems (like, e.g., airbags), and navigation systems), electronic devices for industrial machinery (like, e.g., control units for automation, robotics, and manufacturing equipment).

Examples for sub-assemblies for electronic devices are in particular electronic modules for the electronic devices mentioned above. Examples for modules are in particular electronic control units (ECUs), power supply modules, connectivity or communication modules (like, e.g., HDMI or USB ports, WiFi modules, Bluetooth modules and GSP modules), sensor modules (e.g., heart rate, GPS), microcontroller modules, battery management modules, display interface modules, driver modules, audio modules, RFID modules, and memory modules.

The preferred embodiments presented with reference to a component carrier and its advantages apply correspondingly to the method for manufacturing such a component carrier according to the invention, and to the package as well and vice versa.

Further features of the invention are shown in the claims, the figures and the description of the figures. All the features and combinations of features mentioned above in the description as well as the features and combinations of features mentioned below in the description of the figures and/or shown alone or in combination in the figures can be used not only in the combination as indicated or shown in each case, but also in other combinations or on their own so far it can technically be realized.

### SHORT DESCRIPTION OF THE DRAWINGS

The aspects of the present invention defined above, and further aspects of the invention are apparent from the examples will now be explained in more detail by means of a preferred embodiment example and with reference to the accompanying, but not limiting drawings.

The drawings show:
- **Fig. 1a:**: a schematic cross section through an exemplary embodiment of a component carrier according to the first aspect of the present invention,
- **Fig. 1b:**: a schematic cross section through another exemplary embodiment of a component carrier according to the first aspect of the present invention,
- **Fig. 2a:**: another schematic cross section through the component carrier of Fig. 1a,
- **Fig. 2b:**: an enlarged view of the cross section of Fig. 2a,
- **Fig. 3:**: a schematic perspective view from diagonally above on the protective layer structure of the component carrier of Figs. 1a, 2a and 2b,
- **Fig. 4:**: a schematic perspective view from diagonally above on two neighbored protective layer structures provided in two neighbored openings in the solder resist layer structure of the component carrier,
- **Fig. 5:**: a schematic top view on three neighbored protective layer structures provided in three neighbored openings in the solder resist layer structure of the component carrier,
- **Fig. 6:**: an exemplary flow chart of an exemplary embodiment of a method according to the second aspect of the present invention,
- **Fig. 7:**: the steps of a preferred surface treatment of the solder resist layer structure,
- **Fig. 8a:**: a schematic view of the theoretical wetting behavior of a surface with hydrophilic characteristic,
- **Fig. 8b:**: a schematic view of the theoretical wetting behavior of a surface with hydrophobic characteristic,
- **Fig. 9:**: different SEM-pictures (top views and cross sections) through a component carrier with different shapes of the peripheral portion of the protective layer structure, and
- **Fig. 10:**: further SEM-pictures (cross sections) through a component carrier with different shapes of the peripheral portion of the protective layer structure.

### DETAILED DESCRIPTION

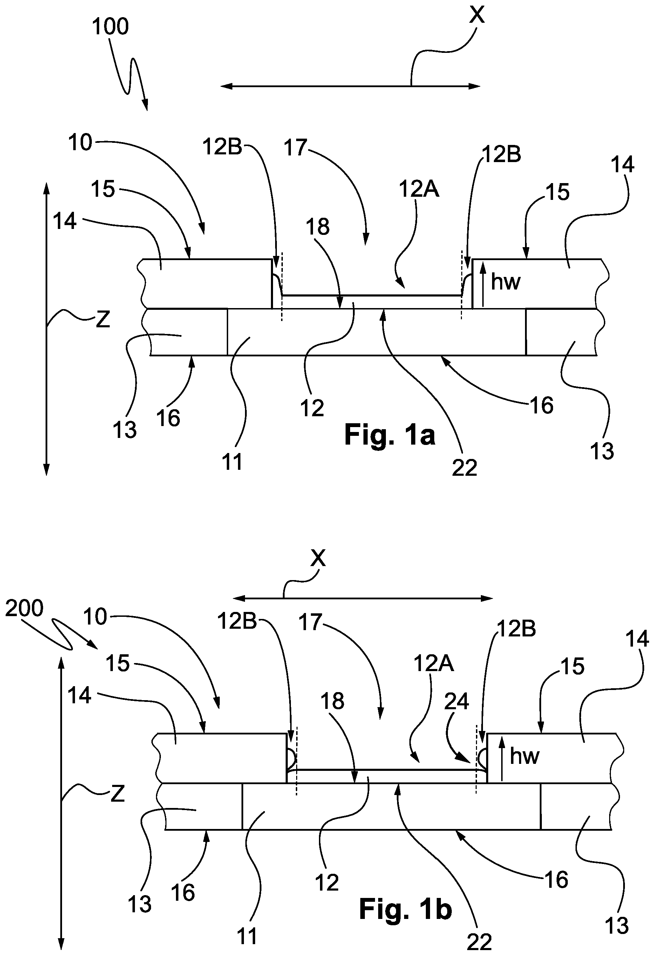

**Fig. 1a****,** **2a****,** **2b** and **3** show several views of a component carrier 100 or parts thereof according to the first aspect of the present invention which will be described in more detail in the following.

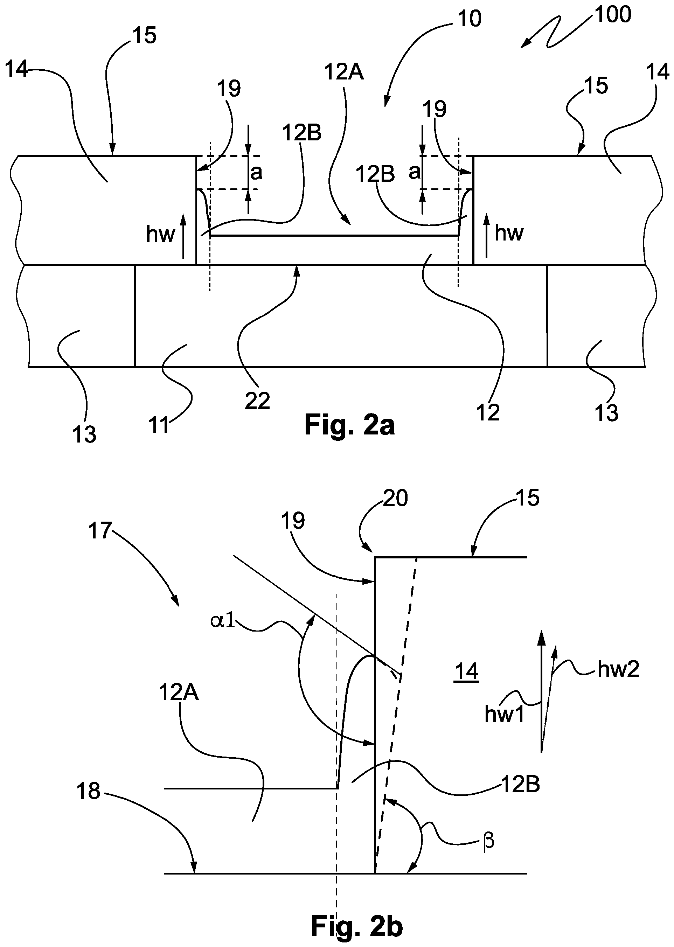

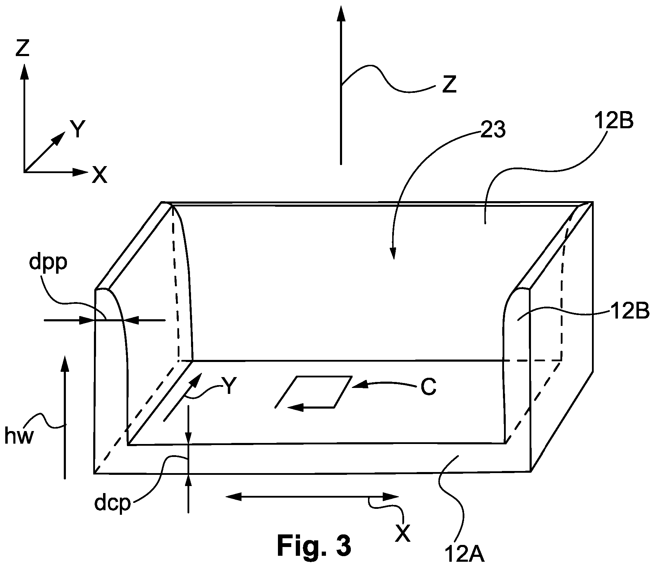

**Fig. 1a** shows a schematic cross section through an exemplary embodiment of a component carrier according to the first aspect of the present invention, **Fig. 2a** shows another schematic cross section through the component carrier of Fig. 1a, **Fig. 2b** shows an enlarged view of the cross section of Fig. 2a, and **Fig. 3** shows a schematic perspective view from diagonally above on the protective layer structure of the component carrier of Figs. 1a, 2a and 2b.

The component carrier 100 comprises a stack 10, wherein the stack 10 comprises one electrically conductive layer structure 11 and a solder resist layer structure 14. The electrically conductive layer structure 11 and the solder resist layer structure 14 are vertically stacked in a stacking direction Z. The solder resist layer structure 14 comprises an opening 17 by which a portion 18 of the electrically conductive layer structure 11, in particular an upper main surface of said conductive layer structure 11, is exposed. On said exposed portion 18 of the electrically conductive layer structure 11 a protective layer structure 12 is provided. In an embodiment, the opening 17 may be a with shape of rectangle, cone, cylindrical, taper and all other shapes based on product design.

The stack 10 of this component carrier 100 comprises two main surfaces 15 and 16. The main surfaces 15 and 16 are located opposite to each other and extending parallel to the plate extension direction X (see Fig. 3), in which also the central portion 12A of the protective layer structure 12 is extending, and perpendicular to the stacking direction Z.

According to the first aspect of the present invention, the protective layer structure 12 comprises an at least substantially plate-shaped central portion 12A having a first thickness distribution dcp = f (X, Y) (see Fig. 3) and a substantially wall-shaped peripheral portion 12B having a second thickness distribution dpp = f (hw, X, Y) (see also Fig. 3).

With this component carrier 100, in particular with the specific design and arrangement of the protective layer structure 12 provided, the risk of occurrence of malfunctions and/or failure over lifetime of a component carrier 100 can be reduced.

By the design of the protective layer structure 12 according to the invention in particular a subsequent soldering process can be improved, in particular its outcome. By the presence of a protective layer structure 12 according to the present invention, a more reliable soldering process can be enabled.

The central portion 12A, in particular a bottom surface 22 of the central portion 12A, is in contact with the exposed portion 18. The peripheral portion 12B is provided at an external side of the central portion 12A and is extending in a wall-height direction hw different from a plate extension direction X, Y of the central portion 12A (see Figs. 2a, 2b and 3). Preferably, at least a part of the peripheral portion 12B is in contact with the exposed portion 18. Alternatively, the peripheral portion 12B may not be in contact with the exposed portion 18.

Therein, the first thickness distribution dcp = f (X, Y) of the central portion 12A is different from the second thickness distribution dpp = f (hw, X, Y) of the protective layer portion 12B.

Preferably, the central portion 12A of the protective layer structure 12 extends planarly, in particular perpendicular to the stacking direction Z, respectively parallel to plate extension direction X and/or Y (see Fig.3).

The peripheral portion 12B of the protective layer structure 12 may extend in a wall-height direction hw1 (see Fig. 2b) parallel to the stacking direction Z or in a wall-height direction hw2 (see Fig 2b) inclined with respect to the plate extension X, Y of the central portion 12A. The inclination (indicated by angle β) may be in a range from 60° up to 90° (see Fig. 2b). In at least one embodiment, the peripheral portion may extend in a direction perpendicular to the central portion (i.e., with an angle β = 90°). Alternatively, the inclination may be in a range from 45° to 60°.

In a preferred embodiment, the wall-shaped portion 12B is in particular slightly inclined with an inclination angle 80° < β < 90°. In a preferred embodiment, the wall-shaped portion 12B is inclined with an inclination corresponding to the inclination of a lateral wall 19 of the solder resist layer structure 14, which is also inclined by this angle β relatively to the exposed surface 18. The inclination of the lateral wall 19 of the solder resist layer structure 14 may in particular be a result of forming the opening 17 in the solder resist layer structure 14, in particular by laser drilling or a photo image process.

In addition to the solder resist layer structure 14 and the conductive layer structure 11, in this exemplary embodiment of a component carrier 100 according to the first aspect of the present invention, in this example, the stack 10 further comprises an insulating layer structure 13 which is arranged in the same plane as the conductive layer structure 11. However, the insulating layer structure 13 which is made from electrically non-conductive material, may alternatively and/or additionally also be arranged in another layer plane. In Fig.1a, the electrically insulating layer structure 13 is free of contact (i.e., not in contact) with the protective layer structure 12. Alternatively, in at least one other possible embodiment, the electrically insulating layer structure may be in (direct) contact with the protective layer structure 12.

As illustrated in Figs. 1a, 2a, 2b and 3, the central portion 12A has a constant thickness dcp over the whole plate extension X, Y. Contrary to the central portion 12A, the peripheral portion 12B has a variable wall thickness dpp, wherein the thickness dpp of the peripheral portion 12 B is decreasing in wall high direction hw respectively hw1 respectively hw2 away from central portion 12A. Alternatively, the wall thickness dpp may be constant over at least a portion in wall high direction hw, hw1 or hw2.

While the central portion 12A may be substantially plate-shaped, in particular a rectangular, circular or oval plate, the peripheral portion 12B may be wall-shaped and extends along a circumference C of the central portion 12A, wherein the peripheral portion 12B in the illustrated example surrounds the central portion 12A completely.

The opening 17 of the solder resist layer structure 14 is delimited by lateral walls 19 and the wall-shaped peripheral portion 12B of the protective layer structure 12 preferably extends in parallel, in particular along, to the lateral wall 19 of the opening 17 in the solder resist layer structure 14. Alternatively, the opening 17 of the solder resist layer structure 14 may be delimited by the wall-shaped peripheral portion 12B of the protective layer structure 12 only. This is, for example, illustrated in Fig. 2b. Fig. 2b also illustrates schematically different inclination angles β of the solder resist layer structure 14. In all illustrated cases the wall-shaped peripheral portion 12B extends in parallel to said lateral wall 19 and is in contact with the lateral wall surface.

The wall-shaped peripheral portion 12B of the protective layer structure 12 is in particular formed such an upper extremity does not exceed over the height of the lateral wall 19. In particular, an upper extremity of the wall-shaped peripheral portion 12B is distanced by a distance "a" from a closest point on the upper edge 20 of the lateral wall 19, wherein this distance "a" is preferably constant, in particular within a deviation of 10 percent from an average of said distance "a", in particular from an arithmetic average of said distance "a". In another embodiment, the deviation of the distance "a" may be smaller than 30 percent. In at least one embodiment (additionally or alternatively), the distance "a" may be constant such that the wall height of lateral sidewall 19 has a deviation of less than 10 percent of an average height of lateral sidewall 19, in particular of an arithmetic average of said height. Thereby, in a very effective manner overplating of the protective layer structure 12 can be avoided and an advantage subsequent soldering is possible.

As illustrated in Fig. 2b, the extremity of the peripheral portion 12B may contact the surface of the lateral wall 19 of the solder resist layer structure 14 with a contact angle α greater than 90°. Alternatively, the contact angle α may be greater than at least 75°.

For reliable soldering in a subsequent soldering process, the protective layer structure 14 is an electrically conductive material and comprises a protecting conductive layer structure or is a protecting conductive layer structure.

Further, for an advantageous, subsequent soldering process, the protective layer structure 14 is configured, in particular shaped, to act as a guiding structure 23 for the solder material to be flowed and electrically connected to the exposed surface 18 of the protective layer structure 12. An advantageous guiding structure 23 is shown, for example, in Fig. 3 (wherein the front wall of the guiding structure is not shown).

In the present example, the guiding structure 23 formed by the protective layer structure 12 has a basin-like shape, wherein the bottom of the present guiding structure 23 is formed by the plate area of the central portion 12A, whilst the wall of the basin 23 is formed by the wall-shaped peripheral portion(s) 12B) of the protective layer structure 12.

The peripheral portion 12B forms a protrusion which protrudes beyond the central portion 12A in stacking direction Z and away from the exposed surface 18 of the conductive layer structure 11.

What is not shown but may be the case in at least one embodiment is, in particular in a preferred embodiment, that the component carrier 100 may comprise a protective layer structure 12 which is a multilayer structure.

What is more, is that the stack 10 also may comprise at least one or more further layer structures and may be formed as multi-stack.

In the present case the protective layer structure 12 comprises a layer made of palladium (Pd). Alternatively, and/or in addition, the protective layer structure may also comprise nickel (Ni) or gold (Au). The conductive layer structure 11 of component carrier 100 is made of copper (Cu). Alternatively, the electrically conductive layer structure 11 may comprise aluminum (Al), chromium (Cr), titanium (Ti), or silver (Ag). Thus, the protective layer material 12 and the conductive layer material 11 are different from each other in the example presented herein.

**Fig. 1b** shows another embodiment of a component carrier 200 according to the first aspect of the present invention, wherein this embodiment in particular differs in the shape of the protective layer structure 12, in particular in a transition zone 24, in which the central portion 12A merges into the here also wall-shaped peripheral portion 12B, wherein in the embodiment illustrated in Fig. 1b, the protective layer structure 12 comprises an undercut, in particular at the outer edge of the central portion 12A. Such an undercut may, for example, be the result of an etching process, in particular of an etching process which has been performed after the protective layer structure 12 has been applied, in particular by a "micro etching process", preferably by "overetching". In some situations, the undercut or overetch may at least partially extend into the solder resist layer 14 and/or the center portion 12A of protective layer structure 12.

In the context of the present application, a "micro etching process" may in particular denote a process by which fine patterns and/or features in a layer structure can be created by selectively removing material by etching, in particular with micrometer dimensions.

In the context of the present application, the term "overetching" may in particular denote an excessive material removal by etching above the wanted amount or out of the specification defined for a product.

Such an undercut may influence the protection properties of the protective layer and/or may influence connection behavior, in particular when exceeding a certain amount. However, up to a certain level such undercuts may tolerable and may therefore be present in some embodiments of a component carrier according to the first aspect of the present invention.

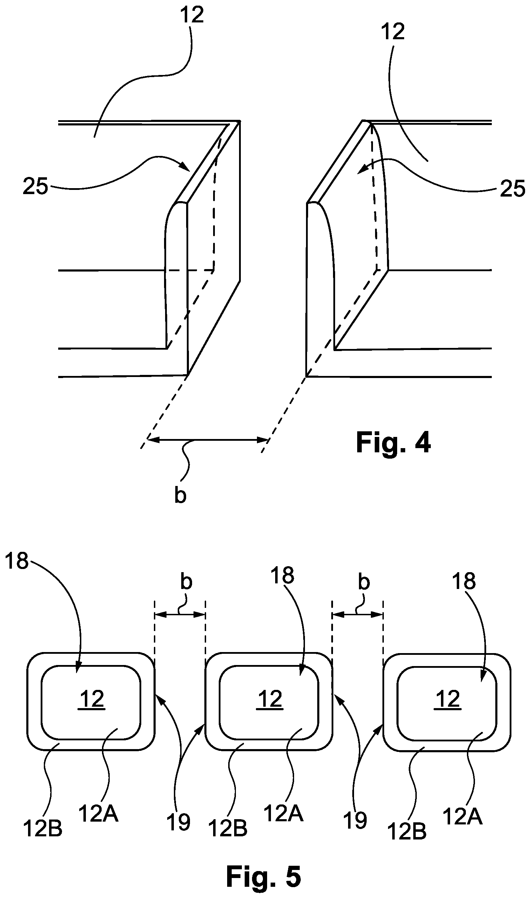

In a preferred embodiment of component carrier 100, the component carrier 100 may comprise several openings 17 with an exposed portion 18 of the conductive layer structure 11 to provide additional contact zones, wherein the exposed portions are covered by a protective layer structure 12 as illustrated in Figs. 4 and 5, for example.

**Fig. 4** shows a schematic perspective view from diagonally above on two neighbored protective layer structures 12 provided in two neighbored openings 17 in the solder resist layer structure 14 of the component carrier 100.

**Fig. 5** shows a schematic top view on three neighbored protective layer structures 12 provided in three neighbored openings 17 in the solder resist layer structure 14 of the component carrier 100.

With a protective layer structure 12 as described having a plate-shaped central portion 12A and a wall-shaped peripheral portion 12B with a defined thickness and height, wherein the peripheral portion 12B in particular does not exceed over the edge 20 of the solder resist layer structure 14, overplating may effectively be avoided, and an advantageous subsequent soldering process may be enabled.

The reduced risk of overplating allows to arrange neighbored peripheral portions 12B of adjacent protective layer structures 12 in corresponding openings 17 to be distanced with a minimum distance "b" down to of 1 µm. Thereby a high packing density can be achieved within a component carrier 100.

In a preferred embodiment and as exemplary illustrated in Fig. 4, the outer surfaces 25 of the adjacent protective layer structures 12 of the (here wall-shaped) peripheral portions 12B, which are in this example in particular curved, here especially convex or rounded, may in particular be facing away from each other, preferably in opposite directions. This may positively influence the component's carrier behavior in at least one further manufacturing or process step after application of the protective layer structure. This structure may reduce the risk of neighbor peripheral portions extending to each other to cause short.

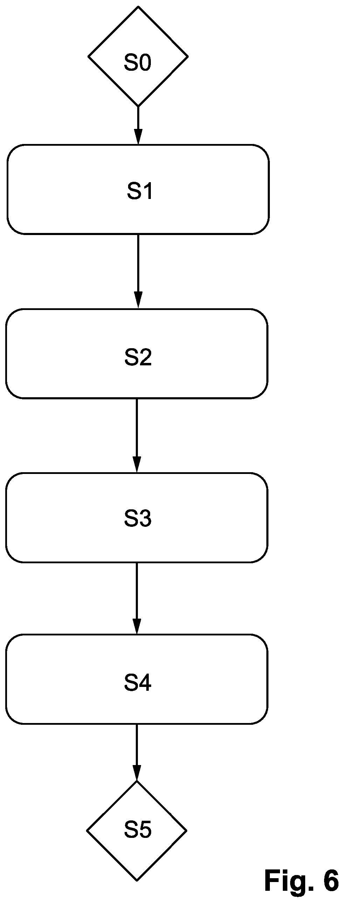

**Fig. 6** shows an exemplary flow chart of an exemplary embodiment of a method for manufacturing a component carrier 100 according to the second aspect of the present invention, wherein after a start in step S0, in a first step S1 the stack 10 of the component carrier 100 is formed.

In a further step S2, a surface treatment may be applied with several treatment steps, wherein in particular a surface activation step for activation of the external surface 15 of the solder resist layer structure 14 is performed. The activation may be performed by a plasma process for example.

By this activation step S2, in addition to the exposed portion 18 of the conductive layer structure 11 also the external surfaces of the solder resist layer structure 14 may in some cases be activated, including the lateral walls(s) 19. Activation of said surfaces may in particular result in establishing an active layer on the respective surfaces, in particular on the surfaces of the solder resist layer 14.

However, it has to be noted that the treatment of the exposed portion, in particular according to step S2 as described above (first surface treatment, preferably for activation) and/or according to step S3 as described above (further surface treatment) are in general optional and have not mandatorily to be performed. However, in many cases it is recommended to do so for advantageous performance in at least one subsequent process step.

The active layer may comprise protonated functional groups, for example -COOH (carboxylic acid) groups, -OH (alcohol) groups, or -SO3H (sulfonic acid) groups, wherein as a result of activation these protonated functional groups (e.g.-COOH) may become reactive functional groups. Preferably, the reactive functional groups comprise or consist of the corresponding conjugated base of the protonated function groups, for example -COO⁻ (carboxylate) groups, -O⁻ (alcoholate) groups, or -SO3⁻ (sulfonate) groups. The reactive functional groups - due to their negative loading - may attract positive atoms or ions, as for example Pd2⁺ as it is provided in a subsequent ENEPIG process for providing the protective layer in step S4.

Due to the attraction forces, positive palladium atoms (Pd2⁺) may as an unwanted result, also be attracted from the solder resist layer structure 14, but not only from the area of the exposed portion 18 of the conductive layer structure 11 to which the protective layer structure should be applied. This may cause overplating when the protective layer structure 12 is provided, in particular if the protective layer structure is provided by an ENEPIG process comprising positive palladium Pd2⁺.

To avoid overplating and/or to at least reduce the risk of overplating, in particular a further surface treatment may be performed which is illustrated in Fig. 6 as step S3. By the further surface treatment preferably the negatively loaded reactive functional groups, for example -COO⁻, are deactivated. This may be done, for example, by removing the active layer from the solder resist layer structure 14, but in particular only from the solder resist layer structure 14 and not from the surface of the exposed portion 18 on which protective layer material has to be deposited.

"Removing" may in particular include at least of the following: reconverting to protonated functional groups, transformation into a further functional group (ester(s), or ether(s)) not interacting with positive charges like Pd2+, mechanical or chemical removal of the functional groups.

By removing the active layer only from the external surfaces 15, 19 of the solder resist layer structure 14, in an easy and effective manner overplating with protective layer material 12 on the solder resist layer structure 14 can be avoided in the surface finish process (step S4), in which the protective layer structure 12 on the exposed portion 18 of the conductive layer structure 11 is provided, for example by an ENEPIG process. However, proper deposition of protective layer material 12 on the surface of the exposed portion 18 of the conductive layer structure 11 can still be ensured without significant disadvantages.

After step S4, the manufactured component carrier 100 may be subject to further process steps, in particular to at least one assembly step to form a package. With S5 the process may terminate.

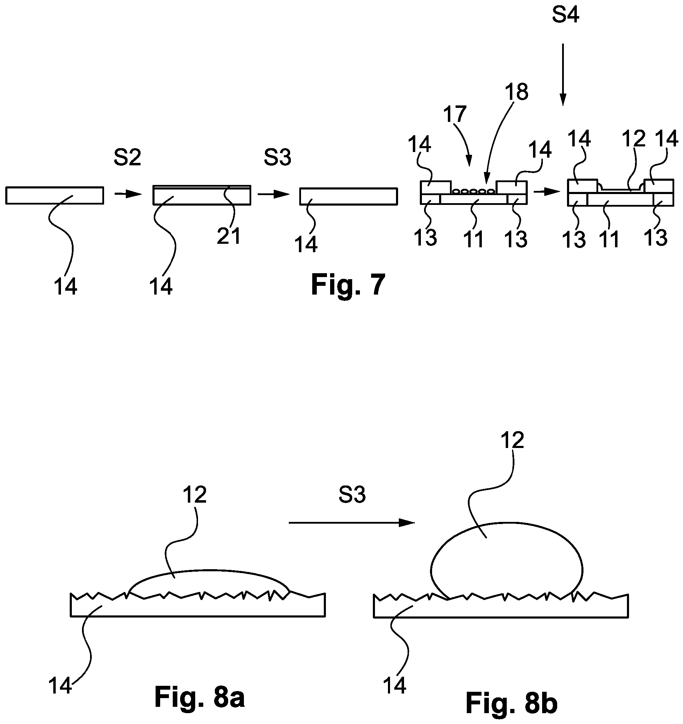

For better understanding of the surface treatment, an exemplary embodiment of a surface treatment is illustrated in Figs. 7, 8a and 8b.

**Fig. 7** shows the steps of a preferred surface treatment of the solder resist layer structure 14, wherein this illustration shows a solder resist layer structure 14, onto which by a first surface treatment, in particular by a plasma treatment, an activation layer 21 is applied (step S2), which is removed by a further treatment step S3 subsequently.

As a result, the exposed portion 18 in the opening 17 remains active due to the negative loaded reactive functional groups, for example -COO⁻, attracting positive (palladium Pd2⁺) atoms or ions, what is wanted for sufficient plating of the protective layer structure 12, whilst the external surface 15 of the solder resist layer structure 14 has been deactivated by said additional surface treatment after activation.

In some embodiments, as a result in a subsequent plating process, the positive palladium Pd2⁺ for example may only be attracted in the area of the opening 17, but not on the external surface(s) 15, 19 of the soldier resist layer structure. As a result, the risk of overplating may decrease. However, this in particular depends on the surface properties of the external surface(s) 15, 19, in particular on the outcome of the previous process(es) and may not be achieved in all embodiments.

It has been found that by changing the surface properties of the solder resist layer structure 14 from hydrophilic to hydrophobic (see Figs. 8a and 8b for explanation of hydrophilic and hydrophobic) during surface treatment before providing the protective layer structure 12 a very advantageous surface finish process is enabled. **Fig. 8a** shows a schematic view of the theoretical wetting behavior of a surface with hydrophilic characteristic, and **Fig. 8b** shows a schematic view of the theoretical wetting behavior of a surface with hydrophobic characteristic. A more hydrophilic surface has better wettability what means more chemicals may easily remain on the surface. Contrary, a hydrophobic surface has worse wettability. With respect to the present application this means that a more hydrophilic solder resist layer structure enables more chemicals to easily remain on its surface, leading to continuous reactions, in particular forming an (unwanted) palladium containing layer structure. Contrary to this, a more hydrophobic surface makes it more difficult for chemicals to remain on the surface and to react and form any (unwanted) layer structure.

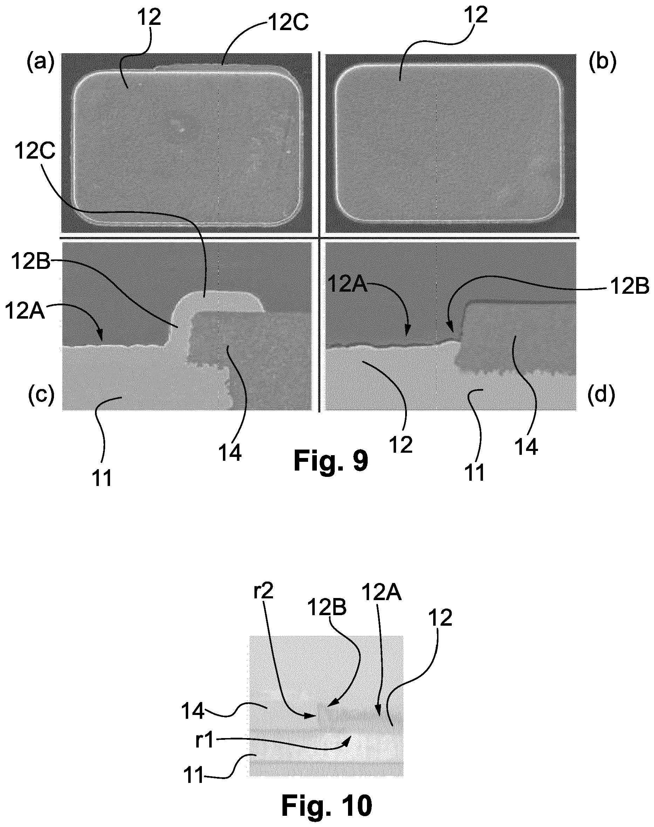

**Fig. 9** shows different SEM-pictures (top views and cross sections) through a component carrier 100 with different shapes of the peripheral portion 12B of the protective layer structure 12, wherein Fig. 9(a) shows a top view of a first SEM picture of a protective layer structure 12 in an opening 17, and wherein Fig. 9(c) shows the corresponding cross section.

In Figs. 9(a) and 9(c) the protective layer structure 12 is provided on an exposed portion 18 of the conductive layer structure 11, wherein in this case a little overplating has been caused. From the cross-section it is visible that the resulting peripheral portion 12B of the protective layer structure 12 does in addition to the wall-shaped portion 12B also comprise a further (additional) portion 12C extending horizontally, in particular parallel to the solder resist layer surface.

This additional, horizontal portion of the protective layer 12, in this case exceeding over the edge 20 of the lateral wall 19, may in some cases be accepted, although this can already be named as overplating. Such a horizontal portion 12C may in particular be accepted, for example, if the length of the additional portion 12C in plate extension direction X, Y does not exceed a defined limit. However, and also if horizontal portions 12C are present, in a preferred embodiment in particular a minimum distance "b" of two adjacent peripheral portions (as described in the context of Fig. 4) be guaranteed - in case of horizontal portions 12C in particular between said horizontal portions 12C (i.e., in a plane extension direction respectively in a direction preferably perpendicular to the stacking direction), wherein said horizontal peripheral portions 12C are in particular arranged with a distance of at least of 1 µm, 3 µm or 5 µm, and in particular up to 10 µm in between, preferably with a distance in a range from 5 µm to 10 µm. Thereby the risk of short circuits and/or other defect patterns may be reduced, in particular sufficiently also with horizontal portions 12C. By providing a more hydrophobic solder resist layer structure surface, in particular by adjusting the surface property of said layer structure to a hydrophobic degree, the planar expansion of the protective layer may be reduced, in particular be influenced or even controlled. This allows as a result to influence, in particular to reduce or even control the risk of short circuits and/or other defect patterns.

Figs. 9(b) and 9(d) show in contrast a picture of an example of a component carrier 100, wherein in this example the peripheral portion 12B does not exceed the lateral wall height of the solder resist structure 14 and therefore no overplating has occurred.

As it is apparent from the pictures, at its upper end the peripheral portion 12B forms a contact angle α of greater than 90° to the lateral wall of the surface of the solder resist layer structure 14. The hydrophobic properties of the solder resist layer structure 14, in particular of its lateral wall(s) 19, help to keep the protective layer material within the opening 17 and don't exceeding over the edge 20 of the solder resist layer structure 14.

In addition to the change of the surface characteristics from hydrophilic to hydrophobic by the additional surface treatment (see Figs. 8a and 8b) to remove the active layer from the external surface 15 of the solder resist layer respectively to deactivate the functional groups after activation, also a roughness of the solder resist layer has changed.

**Fig. 10** shows further SEM-pictures (cross sections) through a component carrier 100 with different shapes of the peripheral portion 12B of the protective layer structure 12, wherein it is apparent from Fig. 10, that the surface roughness r1 between the conductive layer structure 11 and the protectively structure 12 is higher than the roughness r2 between the lateral wall surface of the wall-shaped solder resist layer structure 14 and the external surface 15 of the wall-shaped peripheral portion 12B.

By the reduced roughness r2 compared to the roughness r1 of the surface of the exposed portion 18 floating up the lateral wall 19 of the solder resist layer structure 14 is more difficult, what further helps to decrease the risk of overplating.

### LIST OF REFERENCE SIGNS

- 100: exemplary embodiment of a component carrier according to the first aspect of the present invention
- 10: stack
- 11: conductive layer structure, in particular comprising Cu
- 12: protective layer structure
- 12A: central portion of the protective layer structure
- 12B: peripheral portion of the protective layer structure
- 12C: additional portion of the protective layer structure, in particular horizontal portion
- 13: insulating layer structure
- 14: solder resist layer structure
- 15: (top) main surface of the stack; external surface of the solder resist layer structure
- 16: (bottom) main surface of the stack; (bottom) main surface of the insulating layer structure respective of the conductive layer structure
- 17: opening in the solder resist layer structure
- 18: exposed portion of the conductive layer structure
- 19: lateral wall of the solder resist layer structure
- 20: (upper) edge of the solder resist layer structure
- 21: active layer after activation surface treatment
- 22: (bottom) main surface of protective layer structure
- 23: basin-shaped guiding structure made of the protective layer structure
- 24: transition zone between central portion and peripheral portion, may comprise an undercut
- 25: outer surface of the peripheral portion, may in particular be curved (convex) or rounded

- a: distance between upper wall extremity of the peripheral portion and the closest point on the upper edge of the solder resist layer structure
- b: distance between to neighbored peripheral portions in plate direction / horizontal direction
- C: circumferential direction of the central portion
- dcp: thickness of the central portion of the protective layer structure
- dcp = f (X, Y): (first) thickness distribution of the central portion
- dpp: thickness of the peripheral portion of the protective layer structure
- dpp = f (hw, X, Y): (second) thickness distribution of the peripheral portion

- hw: wall height direction
- hw1: first wall height direction (perpendicular to the plate extension resp. parallel to the stacking direction)
- hw2: second wall high direction (inclined to the plate extension resp. to the stacking direction) by angle β
- r1: first surface roughness (at the lateral wall of the solder resist layer structure resp. at the external surface of the peripheral portion facing towards the lateral wall)
- r2: second surface roughness (at the bottom surface of the central portion of the protective layer structure resp. at the surface of the exposed portion of the conductive layer structure)
- S0..S5: process steps of an exemplary embodiment of a method according to the second aspect of the invention
- X: first plate extension direction
- Y: second plate extension direction
- Z: stacking direction

- α: contact angle (>90 degree) at the upper end of peripheral portion between the protective layer structure and the lateral wall of the surface layer structure with a perpendicular lateral wall
- β: inclination angle of the lateral wall of the solder resist layer structure (= inclination angle between the lateral wall and the main surface plane of the exposed portion of the conductive layer structure

## Claims

1. A component carrier (100) comprising a stack (10), said stack (10) comprising:
at least one electrically conductive layer structure (11), and
a solder resist layer structure (14);
said at least one electrically conductive layer structure (11) and said solder resist layer structure (14) being arranged, in particular stacked, in a stacking direction (Z);
wherein said solder resist layer structure (14) comprises at least one opening (17) by which a portion (18) of the at least one electrically conductive layer structure (11) is exposed,
wherein at least on a part of said exposed portion (18) of the at least one electrically conductive layer structure (11) at least one protective layer structure (12) is provided;
wherein said protective layer structure (12) comprises an at least substantially plate-shaped central portion (12A) having a first thickness distribution (dcp = f (X, Y)) and an at least substantially wall-shaped peripheral portion (12B) having a second thickness distribution (dpp = f (hw, X, Y)),
said central portion (12A) being at least partially in contact with the exposed portion (18); and
said peripheral portion (12B) being at least partially provided at an external side of the central portion (12A) and being at least partially extending in a direction (hw, hw1, hw2) different from a plate extension direction (X, Y) of the central portion (12A);
wherein the first thickness distribution (dcp = f (X, Y)) is different from the second thickness distribution (dpp = f (hw, X, Y)).

2. The component carrier (100) according to claim 1, wherein the central portion (12A) extends at least partially planarly.

3. The component carrier (100) according to any one of the preceding claims, wherein the peripheral portion (12B) of the protective layer structure (12) extends at least partially in a direction inclined (hw2) with respect to the plate extension (X, Y) of the central portion (12A) of the protective layer structure (12).

4. The component carrier (100) according to any one of the preceding claims, wherein the central portion (12A) has a constant thickness (dcp) over the plate extension (X, Y).

5. The component carrier (100) according to any one of the preceding claims, wherein the peripheral portion (12B) has a variable wall thickness (dpp), wherein in particular the thickness (dpp) of the peripheral portion (12B) is decreasing in at least one wall height direction (hw, hw1, hw2) away from the central portion (12A).

6. The component carrier (100) according to any one of the preceding claims, wherein the peripheral portion (12B) of the protective layer structure (12) extends at least partially along a circumference (C) of the central portion (12A) of the protective layer structure (12).

7. The component carrier (100) according to any one of the preceding claims, wherein the at least one opening (17) of the solder resist layer structure (14) is delimited by at least one lateral wall (19), and the at least one portion (12B) of the peripheral portion (12B) of the protective layer structure (12) extends at least substantially parallel, in particular along, to the lateral wall (19) of the opening (17) in the solder resist layer structure (14).

8. The component carrier (100) according to any one of the preceding claims, wherein the extremity of the peripheral portion (12B) contacts the solder resist layer structure (14) at its lateral wall (19) with a contact angle (α) greater than 90 degrees.

9. The component carrier (100) according to any one of the preceding claims, wherein the protective layer structure (12) defines an external surface configured to act as a guiding structure (23) for a solder material to be flowed and electrically connected to the exposed surface (18), in particular wherein the guiding structure (23) comprises a basin-like shape or a basin shape, wherein the bottom of the basin (23) is in particular formed by the plate-shaped central portion (12A) and the wall of the basin (23) by the wall-shaped peripheral portion (12B) of the protective layer structure (12).

10. The component carrier (100) according to claim any one of the preceding claims, wherein the protective layer structure (12) is a multilayer structure.

11. The component carrier (100) according to any one of the preceding claims, wherein a plurality of openings (17) is provided in the solder resist layer structure (14), each of said openings (17) exposing a portion (18) of the at least one electrically conductive layer structure (11), in particular, wherein the peripheral portion (12B) of the protective layer structure (12) provided on the exposed portion (18) is distanced from a further peripheral portion (12B) of a further protective layer structure (12) provided on a further exposed portion (17) being arranged adjacent, wherein said peripheral portion (12B) is in particular distanced at least of 1 µm, 3 µm or 5 µm, and in particular up to 10 µm, from said further peripheral portion (12B).

12. A method for manufacturing a component carrier (100), the method comprising at least the following steps:
a) forming (S1) a stack (10), said stack (10) comprising:
at least one electrically conductive layer structure (11), and
a solder resist layer structure (14);
wherein said at least one electrically conductive layer structure (11) and said solder resist layer structure (14) are being arranged, in particular stacked, in a stacking direction (Z);
wherein said solder resist layer structure (14) comprises at least one opening (17) by which a portion (18) of the at least one electrically conductive layer structure (11) is exposed,
b) providing (S4) at least on a part of said exposed portion (18) of the at least one electrically conductive layer structure (11) at least one protective layer structure 812);
wherein said protective layer structure (12) being provided comprises an at least substantially plate-shaped central portion (12A) having a first thickness distribution (dcp = f (X, Y)), and an at least substantially wall-shaped peripheral portion having a second thickness distribution (dpp = f (hw, X, Y)),
wherein said protective layer structure (12) is being provided such that:
said central portion (12A) is provided at least partially in contact with the exposed portion (18); and
said peripheral portion (12B) is provided at least partially at an external side of the central portion (12A) and being at least partially extending in a direction (hw, hw1, hw2) different from a plate extension direction (X, Y) of the central portion (12A); and
wherein the first thickness distribution (dcp = f (X, Y)) is different from the second thickness distribution (dpp = f (hw, X, Y)).

13. The method according to claim 12, wherein before providing the at least one protective layer structure (12) on said exposed portion (18), the method comprises at least one step (S2, S3) of surface treatment, in particular of the solder resist layer structure (14).

14. The method according to claim 13, wherein by the step of surface treatment (S3) a surface characteristic of the solder resist layer structure (14) is changed, in particular, wherein the surface treatment (S3) of the external surface (15) of the solder resist layer structure (14) comprises a change of the surface tension of its external surface (15), more in particular, wherein the change of the surface tension is configured to impart a hydrophobicity to the external surface (15) of the solder resist layer structure (14).

15. A package, comprising at least one component carrier (100) according to any one of the claims 1 to 19 and/or at least one component carrier (100) manufactured by a method according to any one of the claims 20 to 24, and at least one further part being assembled with the component carrier (100).
